# EUROPEAN PATENT SPECIFICATION

(11) **EP 4 102 945 B1**
(45) Date of publication and mention of the grant of the patent: **22.11.2023**
(21) Application number: 22178249.3
(22) Date of filing: 09.06.2022
(51) Int. Cl.: H05K 7/20, F24D 3/02, F25B 27/02, F24D 3/18, F24D 17/02, F24D 19/10, F24H 15/254, F24F 12/00, F24H 15/32, F24H 15/35, F25B 6/02

(54) **COMPOSITE REFRIGERATION SYSTEM AND DATA CENTER**
VERBUNDKÜHLSYSTEM UND DATENZENTRUM
SYSTÈME DE RÉFRIGÉRATION COMPOSITE ET CENTRE DE DONNÉES

(30) Priority: 10.06.2021 CN 202110650465
(43) Date of publication of application: 14.12.2022
(73) Proprietor: Huawei Digital Power Technologies Co., Ltd., Shenzhen, 518043 (CN)
(72) Inventor: SONG, Jinliang, Shenzhen, 518129 (CN); ZHENG, Yao, Shenzhen, 518129 (CN)
(74) Representative: Gill Jennings & Every LLP

(56) References cited:
- WO-A1-2022/198944
- CN-U- 216 977 223
- US-A1- 2020 288 602

## Description

### TECHNICAL FIELD

This application relates to the air conditioner refrigeration field, and in particular, to a composite refrigeration system, and a data center equipped with the composite refrigeration system.

### BACKGROUND

For an indoor scenario in which a heat source is provided, especially provided in a centralized manner, heat dissipation processing usually needs to be performed on an area in which the heat source is located. A data center is used as an example. A plurality of servers are arranged in the data center, and these servers generate a large amount of heat during running. A refrigeration system of the data center is used to dissipate the heat and cool the data center, to ensure that the server in the data center can run normally in an environment with a preset temperature.

Most of the plurality of servers in the data center are running uninterruptedly. Therefore, the refrigeration system of the data center needs to operate in cooperation with the server for a long time to uninterruptedly dissipate the heat and cool the data center. An existing refrigeration system of a data center cannot effectively recycle heat generated by a cabinet, and long-time operation of the refrigeration system results in a waste of resources.

US2020288602A1 relates to blended operation mode for providing cooling to a heat load.

### SUMMARY

This application provides a composite refrigeration system, and a data center equipped with the composite refrigeration system. The composite refrigeration system may recycle at least a portion of heat generated indoors, to achieve an effect of energy saving and emission reduction. This application specifically includes the following technical solutions.

The invention has been defined in the independent claims. Further specific technical features have been defined in the dependent claims.

According to a first aspect, this application provides a composite refrigeration system, including a refrigeration part, a heat dissipation part, a first pipeline, a second pipeline, and a refrigerant, where the first pipeline is connected between the refrigeration part and the heat dissipation part, and is configured to send the refrigerant from the heat dissipation part to the refrigeration part; the refrigeration part is connected to indoor space, and is configured to use the refrigerant to cool air sent into the indoor space; and the second pipeline is also connected between the refrigeration part and the heat dissipation part, and is configured to send the refrigerant from the refrigeration part to the heat dissipation part, where the heat dissipation part includes a heat exchanger and a cooler, and the heat dissipation part includes three heat dissipation modes for the refrigerant: in a first heat dissipation mode, the heat dissipation part performs air-cooled heat dissipation on the refrigerant by using the cooler alone; in a second heat dissipation mode, the heat dissipation part exchanges heat between the refrigerant and a heat carrier in an external pipeline network by using the heat exchanger alone, to perform heat dissipation; and in a third heat dissipation mode, the heat dissipation part performs heat dissipation on the refrigerant by simultaneously using the cooler and the heat exchanger.

In this application, the composite refrigeration system forms a circulating refrigeration path of the refrigerant through the refrigeration part, the second pipeline, the heat dissipation part, and the first pipeline. When the refrigerant is in the refrigeration part, the refrigerant may be used to cool the air sent into the indoor space, to achieve an effect of reducing an indoor ambient temperature. When the refrigerant flows to the heat dissipation part, the refrigerant may be heat dissipated by using the cooler or the heat exchanger, or simultaneously using the cooler and the heat exchanger, to form three different heat dissipation modes.

The heat exchanger and the external pipeline network form a heat exchange form. When the refrigerant flows through the heat exchanger in a second heat dissipation mode and a third heat dissipation mode, heat exchange may be formed with the heat carrier in the external pipeline network, to implement heat dissipation of the refrigerant and heat transfer to the heat carrier in the external pipeline network at the same time. The external pipeline network may be used as a heating pipe, a hot water pipe, and the like, and correspondingly, the heat carrier may be used as heating, hot water, or the like, thereby implementing energy recycle and reuse.

The cooler is a condenser, the condenser is connected in parallel to the heat exchanger, and the condenser is configured to directly perform air-cooled heat dissipation on the refrigerant. The composite refrigeration system in this application forms a condenser heat dissipation manner, and the condenser may directly perform air-cooled heat dissipation on the refrigerant. The condenser and the heat exchanger are connected in parallel, so that when the heat dissipation part uses the second heat dissipation mode or the third heat dissipation mode, the refrigerant in the heat exchanger may directly exchange heat with the heat carrier in the external pipeline network.

The composite refrigeration system further includes a controller and a first three-way valve. Three ports of the first three-way valve are respectively connected to the second pipeline, the heat exchanger, and the condenser, and the controller controls the first three-way valve to adjust the heat dissipation mode of the heat dissipation part.

The first three-way valve is controlled by the controller. In this way, flow distribution may be performed on a refrigerant flowing into the condenser for heat dissipation and a refrigerant flowing into the heat exchanger for heat exchange, to further control the heat dissipation mode of the heat dissipation part in the composite refrigeration system in this application. Further, a flow quantity of the refrigerant flowing into the heat exchanger is controlled. In this way, a heating temperature of the heat carrier in the external pipeline network may be controlled.

The refrigeration part includes an electronic expansion valve, an evaporator, and a compressor that are sequentially connected, the electronic expansion valve is located on a side that is of the evaporator and that is close to the first pipeline, and the compressor is located on a side that is of the evaporator and that is close to the second pipeline.

The evaporator is configured to cool air sent into the indoor space. The electronic expansion valve is configured to reduce pressure of the refrigerant, to facilitate evaporation and heat absorption of the refrigerant in the evaporator. The compressor is configured to compress the refrigerant, to increase the pressure and a temperature of the refrigerant, and restore a liquid state of the refrigerant, thereby facilitating heat exchange efficiency between the refrigerant and the heat carrier.

The composite refrigeration system further includes a circulating ventilation channel. An air supply port and an air outlet port of the circulating ventilation channel are separately connected to the indoor space. The refrigeration part is disposed in the circulating ventilation channel and is configured to refrigerate air flowing out of the air outlet port, and send refrigerated air into the indoor space through the air supply port.

The circulating ventilation channel may implement air circulation inside the indoor space. After air sent out from the indoor space is cooled by the refrigeration part, low-temperature air is returned to the indoor space, to ensure cleanness of air in the indoor space.

In a possible implementation, the cooler is a dry cooler, the dry cooler is connected in parallel to the external pipeline network, and the dry cooler performs air-cooled heat dissipation on the heat carrier to implement indirect air-cooled heat dissipation on the refrigerant.

In this implementation, the composite refrigeration system in this application forms a dry cooler heat dissipation manner. After all refrigerants flow through the heat exchanger and complete heat dissipation with the heat carrier in the external pipeline network, the dry cooler may further perform air-cooled heat dissipation on the heat carrier, and further control the heating temperature of the heat carrier, to implement the indirect air-cooled heat dissipation on the refrigerant.

In a possible implementation, the composite refrigeration system further includes a controller and a second three-way valve. Three ports of the second three-way valve are respectively connected to the heat exchanger, the external pipeline network, and the dry cooler, and the controller controls the second three-way valve to adjust the heat dissipation mode of the heat dissipation part.

In this implementation, the second three-way valve is controlled by the controller. In this way, after heat exchange between the refrigerant and the heat carrier is completed, flow distribution may be performed on a heat carrier flowing into the dry cooler for heat dissipation and a heat carrier flowing into a back end of the external pipeline network, to further control the heating temperature of the heat carrier in the external pipeline network of the composite refrigeration system in this application.

In a possible implementation, the composite refrigeration system is provided with a temperature sensor. The temperature sensor is disposed in the indoor space for monitoring a temperature in the indoor space, the temperature sensor is electrically connected to the controller, and the controller controls the first three-way valve or the second three-way valve with reference to a temperature value detected by the temperature sensor.

In this implementation, a temperature rise range of the refrigerant in the refrigeration part may be determined by monitoring an indoor temperature by the temperature sensor. To be specific, when the indoor temperature is relatively low, a cooling degree of the refrigerant to air sent into the indoor space is relatively low when the refrigerant flows through the refrigeration part, and temperature rise of the refrigerant is relatively low. At this time, heat transferred by the refrigerant to the heat carrier through the heat exchange is relatively low. The controller may increase a flow quantity of a refrigerant flowing into the heat exchanger or decrease a flow quantity of a heat carrier flowing into the dry cooler, to increase the heating temperature of the heat carrier. However, when the indoor temperature is relatively high, the controller decreases the flow quantity of the refrigerant in the heat exchanger or increases the flow quantity of the heat carrier in the dry cooler, to decrease the heating temperature of the heat carrier. In both control manners, the heating temperature of the heat carrier may be kept relatively balanced.

In a possible implementation, a heat exchange core is further disposed in the circulating ventilation channel. The heat exchange core is located between the air outlet port and the refrigeration part, external air flows at the heat exchange core, and the heat exchange core is configured to introduce the external air to perform pre-refrigeration on the air flowing out of the air outlet port.

In this implementation, the heat exchange core may be disposed to pre-refrigerate air in the circulating ventilation channel, to reduce a temperature of air flowing to the refrigeration part, and further reduce power consumption of the composite refrigeration system in this application. At the same time, a temperature of air outside the heat exchange core is lower than a temperature of the refrigerant or the heat carrier in the heat dissipation part, and the air may further assist heat dissipation of the condenser or the dry cooler.

According to a second aspect, this application provides a data center, where the data center includes an equipment room and the composite refrigeration system provided in the first aspect of this application. The refrigeration part of the composite refrigeration system is connected to indoor space of the equipment room.

In the second aspect of this application, because the equipment room of the data center uses the composite refrigeration system in the first aspect for heat dissipation, the data center in this application also has the foregoing energy recycling function, which is more energy-saving and environment-friendly.

In a possible implementation, the composite refrigeration system includes a controller, the data center includes a server, the controller is further communicatively connected to the server, and the controller further controls a heat dissipation mode of the composite refrigeration system with reference to a workload of the server.

In this implementation, the controller may monitor the workload of the server through being communicatively connected to the server in the data center. When the workload of the server is relatively high, heat generated by the server is relatively high. In this case, the composite refrigeration system in this application needs to increase a refrigerating intensity of the refrigeration part, to make a greater cooling range of air sent into the indoor space, and ensure an indoor heat dissipation effect. Because a temperature of the refrigerant is relatively increased, the controller may decrease a flow quantity of a refrigerant in the heat exchanger or increase a flow quantity of the heat carrier in the dry cooler, to reduce a heating temperature of the heat carrier. Conversely, when the workload of the server is relatively low, the flow quantity of the refrigerant flowing into the heat exchanger is increased, or the flow quantity of the heat carrier flowing into the dry cooler is decreased. In both control manners, the heating temperature of the heat carrier may be kept relatively balanced.

### BRIEF DESCRIPTION OF DRAWINGS

FIG. 1 is a schematic diagram of an application scenario of a composite refrigeration system according to this application;
FIG. 2 is a schematic diagram of a refrigeration path in a composite refrigeration system according to this application;
FIG. 3 is a schematic diagram of a refrigeration part in a composite refrigeration system according to this application;
FIG. 4 is a schematic diagram of a circulating state of a refrigerant in a composite refrigeration system according to this application;
FIG. 5 is a schematic diagram of a structure of a heat dissipation part in a composite refrigeration system according to this application;
FIG. 6 is another schematic diagram of a refrigeration path in a composite refrigeration system according to this application;
FIG. 7 is another schematic diagram of a heat dissipation part in a composite refrigeration system according to this application;
FIG. 8 is another schematic diagram of an application scenario of a composite refrigeration system according to this application;
FIG. 9 is another schematic diagram of an application scenario of a composite refrigeration system according to this application; and
FIG. 10 is another schematic diagram of an application scenario of a composite refrigeration system according to this application.

### DESCRIPTION OF IMPLEMENTATIONS

To make the objectives, technical solutions, and advantages of this invention clearer, the following further describes various implementations in detail with reference to the accompanying drawings. The implementations described below are not all claimed, they are included to help understanding the context of the invention. While the description refers to various implementations, the embodiments of the invention are those that comprise at least all the features of an independent claim. Any implementation that does not fall within the scope of the claims does not form part of the invention, but rather included as an illustrative example that is useful for understanding the invention.

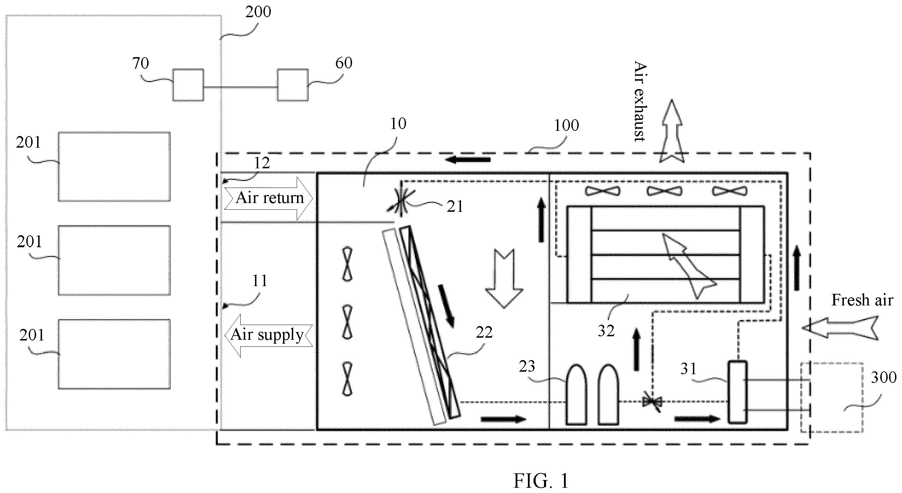

The composite refrigeration system in this application may be used in an indoor environment with a heat source, and is particularly applicable to an indoor environment in which the heat source is centrally arranged, for example, may be used in a data center. The following uses a data center as an example for description. FIG. 1 is a schematic diagram of an application scenario of applying a composite refrigeration system 100 in the data center according to this application. The data center includes an equipment room 200, and at least one IT device (for example, a server 201) or/and a power supply apparatus is/are arranged in the equipment room 200. When the at least one IT device or/and the power supply apparatus is/are running, a large amount of heat is generated. The composite refrigeration system 100 in this application is configured to implement refrigeration and heat dissipation of the data center. In this implementation of this application, the data center may be a micro-modular data center, or may be a prefabricated data center, or may be a floor or room formed in a building and used to place an IT server. Based on the data centers in the foregoing different forms, the composite refrigeration system 100 may be disposed inside the equipment room 200 of the data center, or may be disposed outside the equipment room 200, or may be partially disposed inside the equipment room 200 and partially disposed outside the equipment room 200.

In some implementation scenarios, in addition to the IT device and the power supply apparatus, a concept of the data center further includes a temperature control system and another auxiliary device. Therefore, the composite refrigeration system 100 in this implementation of this application may also be considered as a part of the data center.

In the illustration of FIG. 1, the composite refrigeration system 100 in this application includes a circulating ventilation channel 10. The circulating ventilation channel 10 includes an air supply port 11 and an air outlet port 12. The air supply port 11 and the air outlet port 12 are separately connected to the equipment room 200 of the data center. The air supply port 11 is configured to send refrigerated air (marked as fresh air in the figure) into the equipment room 200 of the data center. The air outlet port 12 is configured to draw air in the equipment room 200 of the data center into the circulating ventilation channel 10 (marked as return air in the figure), and refrigerate the air.

Thus, the equipment room 200 of the data center and the circulating ventilation channel 10 form a sealed circulating ventilation path. The composite refrigeration system 100 may carry, through air flowing out of the air outlet port 12, heat generated by the server 201 during operation out of the equipment room. The air is refrigerated and heat dissipated by the composite refrigeration system 100 in this application, and is sent back to the equipment room from the air supply port 11, to implement overall heat dissipation of the equipment room 200 of the data center. In the implementation shown in FIG. 1, the air supply port 11 is located below the air outlet port 12. Cold air sent from the air supply port 11 flows upwardly in the equipment room, to balance an air temperature in the equipment room.

In the structure shown in FIG. 1, the entire composite refrigeration system 100 is disposed outside the equipment room 200. However, in some other implementations, the composite refrigeration system 100 may be alternatively partially disposed inside the equipment room 200, and the circulating ventilation channel 10 may be formed through isolation of space inside the equipment room 200, without affecting specific implementation and deployment of the solution of this application.

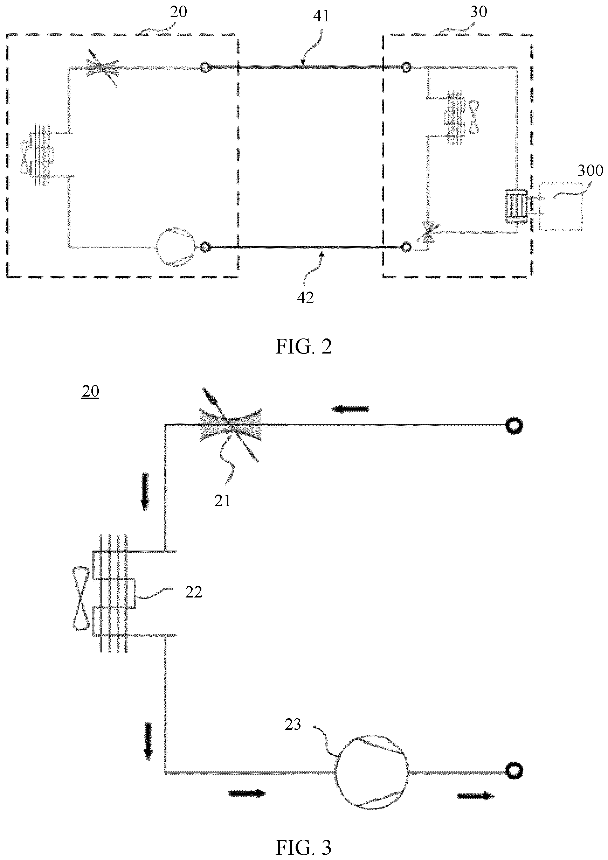

Referring to FIG. 2, the composite refrigeration system 100 in this application includes a refrigeration part 20, a heat dissipation part 30, a first pipeline 41, and a second pipeline 42. The refrigeration part 20, the heat dissipation part 30, the first pipeline 41, and the second pipeline 42 are connected to form a refrigeration path. The composite refrigeration system 100 further includes a refrigerant. The refrigerant flows through the refrigeration path (a black arrow is used to indicate a flow direction of the refrigerant in the figure) to achieve an effect of refrigerating air sent into the equipment room 200 of the data center. The refrigerant may be implemented by using a coolant, such as Freon (fluorine saturated with hydrocarbons, chlorine, and bromide derivatives), azeotropic mixture (an azeotropic solution of two freon mixtures in a specific proportion), hydrocarbon (dimethylmethane, ethylene, and the like), and ammonia. These coolants can implement liquefaction and facilitate refrigeration at a normal temperature or lower temperature.

The first pipeline 41 and the second pipeline 42 are separately connected between the refrigeration part 20 and the heat dissipation part 30. The first pipeline 41 is configured to send the refrigerant from the heat dissipation part 30 to the refrigeration part 20, and the second pipeline 42 is configured to send the refrigerant from the refrigeration part 20 to the heat dissipation part 30. The refrigeration part 20 is disposed in the circulating ventilation channel 10, and is configured to cool and refrigerate, by using the refrigerant, the air sent into the equipment room 200 of the data center. A process in which the refrigerant cools and refrigerates the air may be understood as a process in which the refrigerant exchanges heat with the air. A temperature of the refrigerant that is cooled and refrigerated in the refrigeration part 20 is increased, and the heat dissipation part 30 is configured to dissipate heat of the refrigerant.

Referring to FIG. 3, a structure of the refrigeration part 20 is illustrated according to the claimed disclosure. The refrigeration part 20 includes an electronic expansion valve 21, an evaporator 22, and a compressor 23 that are sequentially connected. The evaporator 22 is located between the electronic expansion valve 21 and the compressor 23. The electronic expansion valve 21 is located on a side that is of the evaporator 22 and that is close to the first pipeline 41, and the compressor 23 is located on a side that is of the evaporator 22 and that is close to the second pipeline 42. To be specific, a refrigerant sent from the heat dissipation part 30 through the first pipeline 41 reaches the evaporator 22 after the refrigerant passes through the electronic expansion valve 21. The refrigerant then flows from the evaporator 22 to the compressor 23 and flows into the heat dissipation part 30 through the second pipeline 42.

Specifically, the electronic expansion valve 21 is configured to throttle and depressurize the refrigerant, so that the refrigerant is converted from a liquid state to a gas-liquid mixed state. The evaporator 22 is configured to make the refrigerant evaporate and absorb heat, to implement heat exchange between the refrigerant and the air sent into the equipment room 200 of the data center. In other words, the evaporator 22 is configured to cool the air sent into the equipment room 200 of the data center. The compressor 23 is configured to pressurize the refrigerant, so that the refrigerant is converted from the gas-liquid mixed state to a high-temperature liquid state, and is sent to the heat dissipation part 30 for heat dissipation. In some implementations, the compressor 23 may convert a portion of the refrigerant into a liquid state, and formation of the entire liquid state of the refrigerant may also be completed in the heat dissipation part 30.

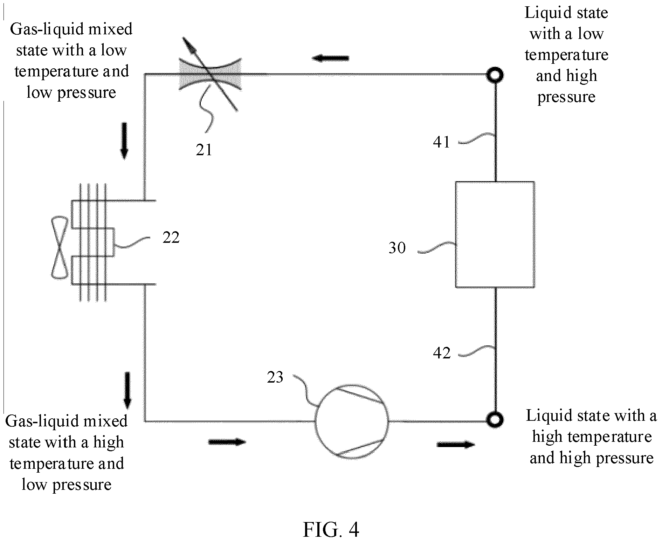

For details, refer to the schematic diagram of a state and a temperature cycle of a refrigerant in a refrigeration path shown in FIG. 4. Because the heat dissipation part 30 is configured to dissipate heat for the refrigerant, a temperature of a refrigerant flowing into the electronic expansion valve 21 from the first pipeline 41 is relatively low. At this time, the refrigerant is in a low-temperature and high-pressure liquid state. After the electronic expansion valve 21 throttles and depressurizes the refrigerant, the refrigerant is converted from a low-pressure liquid state to a low-pressure gas-liquid mixed state, and the temperature is maintained at a low temperature. The evaporator 22 makes the refrigerant evaporate and absorb heat, and then the refrigerant is in a high-temperature and low-pressure gas-liquid mixed state. In some scenarios, the refrigerant is alternatively directly in a high-temperature and low-pressure gas state. The compressor 23 exerts pressure on the refrigerant to convert the refrigerant from a gas state or a gas-liquid mixed state into a high-temperature and high-pressure liquid state. In this way, the refrigerant completes circulation of refrigeration work in the refrigeration path.

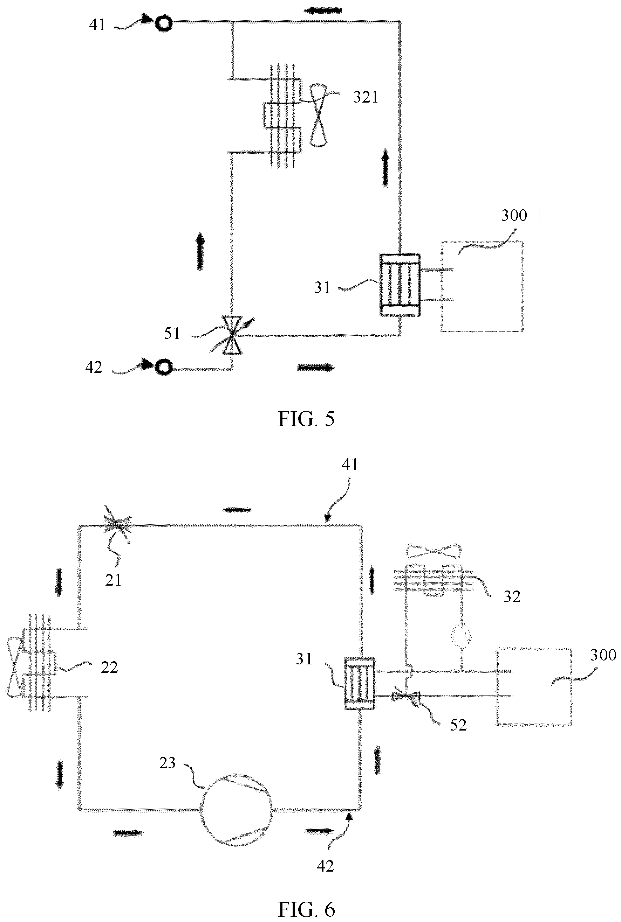

Referring back to FIG. 1 and FIG. 2, and referring to FIG. 5 together, a structure of the heat dissipation part 30 is illustrated. The composite refrigeration system 100 in this application includes a heat exchanger 31 and a cooler 32 on a side of the heat dissipation part 30. The heat dissipation part 30 is configured to perform heat dissipation and cooling on the refrigerant. The heat dissipation part 30 includes three heat dissipation modes: In a first heat dissipation mode, the heat dissipation part 30 performs air-cooled heat dissipation on the refrigerant by using the cooler 32 alone; in a second heat dissipation mode, the heat dissipation part 30 exchanges heat with the external pipeline network 300 by using the heat exchanger 31 alone, and exchanges heat of the refrigerant to the heat carrier in the external pipeline network 300, to implement heat dissipation of the refrigerant; and in a third heat dissipation mode, the heat dissipation part 30 performs heat dissipation on the refrigerant by simultaneously using the heat exchanger 31 and the cooler 32.

According to the claimed disclosure, as shown in FIG. 5, the heat exchanger 31 is connected in parallel to the cooler 32, and the cooler 32 is implemented in a form of a condenser 321. After entering the heat dissipation part 30 from the second pipeline 42, the refrigerant may flow into the condenser 321 or the heat exchanger 31 alone to implement heat dissipation (that is, the first or the second heat dissipation mode), or may be divided in the heat dissipation part 30, where a part flows into the condenser 321 for heat dissipation, and the other part flows into the heat exchanger 31 for heat dissipation. In other words, the heat exchanger 31 and the condenser 321 may be simultaneously used to implement heat dissipation of the refrigerant in the heat dissipation part 30 (that is, the third heat dissipation mode).

When the refrigerant flows into the condenser 321, the condenser 321 is provided with a heat dissipation fin and a fan, so that the refrigerant may be directly heat dissipated through air cooling. In this implementation, the heat exchanger 31 is disposed opposite to the external pipeline network 300. When flowing through the heat exchanger 31, the refrigerant may implement heat exchange with the external pipeline network 300. Specifically, a heat carrier (not shown in the figure) flows in the external pipeline network 300, and the external pipeline network 300 and the heat exchanger 31 form a heat exchange connection structure. In some implementations, the heat exchanger 31 may be implemented in a form of a plate heat exchanger. When flowing through the heat exchanger 31, the refrigerant may implement heat exchange with the heat carrier in the external pipeline network 300. A high temperature of the refrigerant may be transferred to the heat carrier with a relatively low temperature. To be specific, after the refrigerant heats the heat carrier, a temperature of the refrigerant is relatively decreased to achieve a heat dissipation effect, and a temperature of the heat carrier is relatively increased. The external pipeline network 300 may be connected to a local heating pipe, a hot water pipe, or the like. Correspondingly, the heat carrier may be water, and may be used as heating water or domestic hot water.

In the composite refrigeration system 100 according to this application, when the equipment room 200 of the data center is refrigerated and heat dissipated, at least a portion of heat generated in a refrigeration process can be transferred to the external pipeline network 300 by using the heat exchanger 31, to implement energy recycle and reuse. Compared with another solution of an implementation in which the refrigerant is directly heat dissipated by using the cooler 32 alone, the composite refrigeration system 100 in this application has more energy-saving and environment-friendly effects.

For example, it is calculated that heat generated by the composite refrigeration system 100 for one hour of refrigeration is 80 kWh. After operating in the second heat dissipation mode for two hours, the composite refrigeration system 100 may provide 160 kWh of heat to the external pipeline network 300. After operating in the second heat dissipation mode throughout a day, the composite refrigeration system 100 may provide 1920 kWh of heat to the external pipeline network 300. The heat may produce a better heating effect for the external pipeline network 300. According to the claimed disclosure, as illustrated in FIG. 5, the composite refrigeration system 100 further includes a first three-way valve 51. The first three-way valve 51 is connected between the second pipeline 42, the heat exchanger 31, and the condenser 321, and is configured to adjust a heat dissipation mode of the heat dissipation part 30. Specifically, the first three-way valve 51 has a first liquid inlet port and two first liquid outlet ports. The first liquid inlet port is connected to the second pipeline 42, one first liquid outlet port is connected to the condenser 321, and the other first liquid outlet port is connected to the heat exchanger 31. Therefore, a refrigerant in a high-temperature liquid state is sent from the compressor 23 may enter the first three-way valve 51 from the first liquid inlet port, and then flow to the condenser 321 and the heat exchanger 31 from the two first liquid outlet ports respectively. It may be understood that a flow quantity of the refrigerant flowing into the first three-way valve 51 from the first liquid inlet port is equal to or nearly equal to a sum of flow quantities of refrigerants flowing out of the first three-way valve 51 from the two first liquid outlet ports. In other words, a sum of flow quantities of refrigerants flowing through the condenser 321 and the heat exchanger 31 is the same as a flow quantity in the second pipeline 42.

In some implementations, respective flow quantities of the two first liquid outlet ports of the first three-way valve 51 may be adjusted. The composite refrigeration system 100 in this application is further provided with a controller 60 (refer to FIG. 1). The controller 60 is electrically connected to the first three-way valve 51, and is configured to control operation of the first three-way valve 51. The controller 60 may control the first three-way valve 51, to distribute a flow quantity of a refrigerant flowing into the heat exchanger 31 and a flow quantity of a refrigerant flowing into the condenser 321.

The controller 60 may distribute the flow quantity of the refrigerant based on a heat dissipation requirement of the refrigerant, or based on a heating temperature required by the heat carrier. For example, when heat dissipation effects of the condenser 321 and the heat exchanger 31 are different, if the refrigerant needs to obtain a better heat dissipation effect, the controller 60 may control the first three-way valve 51, so that more of the refrigerant flows through a path with a better heat dissipation effect. In this way, a refrigerant with a larger flow quantity can obtain better heat dissipation. For example, when the heat dissipation effect of the condenser 321 is better than that of the heat exchanger 31, the controller 60 may control the first three-way valve 51, so that more of the refrigerant flows out of the first liquid outlet port connected to the condenser 321 and enters the condenser 321 to obtain better heat dissipation. Correspondingly, in this case, a flow quantity of a refrigerant flowing into the heat exchanger 31 from the first liquid outlet port is relatively decreased, and a heating effect of the heat exchanger 31 on the heat carrier is decreased accordingly.

In some implementations, the controller 60 may further control a difference in the heat dissipation effects between the condenser 321 and the heat exchanger 31 by controlling a fan speed of the condenser 321 or controlling a flow rate of the heat carrier in the external pipeline network 300. That the controller 60 controls the flow rate of the heat carrier in the external pipeline network 300 may be implemented as that the controller 60 directly controls the external pipeline network 300, or that the controller 60 is communicatively connected to a control system of the external pipeline network 300, and the controller 60 indirectly controls the flow rate of the heat carrier. In addition, the heat dissipation effect of the condenser 321 may be worse than a heat exchange effect of the heat exchanger 31. In this scenario, when the refrigerant needs to implement better heat dissipation, the controller 60 needs to control more of the refrigerant to flow into the heat exchanger 31.

The controller 60 controls distribution of the flow quantity of the refrigerant based on the heating temperature required by the heat carrier. This may be implemented based on the following scenario: on a premise that the flow rate of the heat carrier in the external pipeline network 300 is given, if an external ambient temperature is relatively low, an initial temperature of the heat carrier is lower before the heat carrier exchanges heat with the refrigerant at the heat exchanger 31. In this case, through control of the controller 60, a flow quantity of a refrigerant flowing into the heat exchanger 31 is larger, and a temperature of heating the heat carrier by the refrigerant is increased, so that an increasing range of a temperature obtained after heat exchange is performed on the heat carrier is larger. If the external ambient temperature is relatively high, the initial temperature of the heat carrier increases accordingly. In this case, through control of the controller 60, a flow quantity of the refrigerant flowing into the heat exchanger 31 may be smaller, and the temperature of heating the heat carrier by the refrigerant is decreased, so that the increasing range of the temperature obtained after heat exchange is performed on the heat carrier is smaller.

The foregoing application scenario related to the external ambient temperature may be used to seasonally adjust a heat dissipation manner of the composite refrigeration system 100. For example, in winter when the external ambient temperature is relatively low, the controller 60 may control more of the refrigerant to flow into the heat exchanger 31, or control all the refrigerant to flow into the heat exchanger 31, so that the heat carrier with a relatively low temperature in the external pipeline network 300 obtains a greater temperature rise through heat exchange; while in summer when the external ambient temperature is relatively high, the controller 60 may control more of the refrigerant to flow into the condenser 321, or control all the refrigerant to flow into the condenser 321, so that the heat carrier with a relatively high temperature in the external pipeline network 300 obtains a smaller temperature rise or a temperature rise of zero through exchange. It may be understood that when the external pipeline network 300 is a heating pipeline network, the external pipeline network 300 does not need to operate in summer, and therefore the heat carrier does not need to form heat exchange with the composite refrigeration system 100. When the external pipeline network 300 is a hot water pipe, an amount of hot water used in summer and a temperature of use are decreased accordingly, and the heating temperature required by the heat carrier is also decreased accordingly.

In an implementation, still referring to FIG. 1, the composite refrigeration system 100 in this application is further provided with a temperature sensor 70. The temperature sensor 70 is disposed in the equipment room 200 of the data center, and is configured to monitor a temperature in the equipment room 200 of the data center. The temperature sensor 70 is communicatively connected to the controller 60 to transmit a detected temperature value of the equipment room 200 of the data center to the controller 60. After receiving the temperature value, the controller 60 may control the first three-way valve 51 to distribute a flow quantity of the refrigerant.

Specifically, in this implementation, a real-time temperature value of the equipment room 200 of the data center detected by the temperature sensor 70 may be used to determine a range of cooling, by the refrigeration part 20, air sent into the equipment room 200 of the data center. To be specific, when the temperature value of the equipment room 200 of the data center is relatively low, the range of cooling the air by the refrigeration part 20 by using the refrigerant is also decreased accordingly. In this case, heat absorbed by a refrigerant in the refrigeration part 20 through evaporation is also decreased accordingly, and a temperature rise range of the refrigerant in a refrigeration process is decreased accordingly. Therefore, heat that can be supplied by the refrigerant to the heat carrier through exchange in the heat exchanger 31 is decreased accordingly, and a heating effect of the heat carrier is reduced. In this case, the controller 60 controls the first three-way valve 51, so that more of the refrigerant may be distributed to flow into the heat exchanger 31, and further, more exchangeable heat is provided for the heat carrier, to maintain a heating effect of the refrigerant on the heat carrier. Conversely, when the real-time temperature value of the equipment room 200 of the data center detected by the temperature sensor 70 is relatively high, the heat that can be supplied by the refrigerant to the heat carrier in the heat exchanger 31 is increased. In this case, the controller 60 controls the first three-way valve 51, so that more of the refrigerant may be distributed to flow into the condenser 321 for direct heat dissipation, less exchangeable heat is provided by the refrigerant in the heat exchanger 31, and the heating effect of the refrigerant on the heat carrier is more balanced.

In an implementation, the controller 60 is alternatively communicatively connected to the server 201 in the equipment room 200 of the data center for monitoring a real-time workload of the server 201 and then controlling flow distribution of a refrigerant in the first three-way valve 51 based on the workload. Specifically, the temperature in the equipment room 200 of the data center is further related to the workload of the server 201. When the workload of the server 201 is relatively heavy, heat generated when the server 201 operates is relatively high, and the composite refrigeration system 100 needs to increase a refrigerating intensity of the server 201, to reduce a temperature of air sent into the equipment room 200 of the data center. In this way, an ambient temperature in the equipment room 200 of the data center is relatively balanced. The ambient temperature is not increased accordingly with an increase of the workload of the server 201, and operation efficiency of the server 201 is not affected. It may be understood that a refrigerating intensity of the composite refrigeration system 100 is increased, and a temperature of a refrigerant flowing out of the refrigeration part 20 is also increased accordingly. In this case, the controller 60 needs to distribute more of the refrigerant to the condenser 321 for heat dissipation, to reduce a flow quantity of the refrigerant in the heat exchanger 31. Such control may make heat supplied by the refrigerant in the heat exchanger 31 to the heat carrier relatively constant. The heat carrier does not obtain more heat with an increase of a temperature of the refrigerant, and it is ensured that the heat carrier achieves a more balanced heating effect. Conversely, when the workload of the server 201 is relatively low, relatively less heat is generated in an operation process of the server 201, and a refrigerating intensity of the refrigeration part 20 on the air by using the refrigerant is decreased. In this case, the controller 60 may distribute more of the refrigerant to flow into the heat exchanger 31, to maintain the heating effect of the refrigerant on the heat carrier.

Because there may be a plurality of servers 201 in the equipment room 200 of the data center, that the controller 60 is communicatively connected to the server 201 may be that the controller 60 is separately communicatively connected to the plurality of servers 201, and separately monitors workloads of the servers 201. Finally, a flow quantity of the refrigerant is distributed in a manner of calculating an average value. In some other implementations, the controller 60 may be alternatively communicatively connected to only one or some of the servers 201 in the equipment room 200 of the data center, and distribute the flow quantity of the refrigerant based on a workload of the one or some of the servers 201. All the foregoing implementations may ensure that the heating effect of the refrigerant on the heat carrier in the external pipeline network 300 is consistent when the composite refrigeration system 100 operates effectively.

In some other implementations, the controller 60 may alternatively receive the temperature value obtained through monitoring by the temperature sensor 70 and workload data of the server 201 at the same time, and distribute a flow quantity of the refrigerant in the heat dissipation part 30 based on the temperature value in the equipment room 200 of the data center and a workload status of the server 201 at the same time, to ensure a refrigerating effect of the composite refrigeration system 100 and the heating effect on the heat carrier at the same time.

It should be noted that, in the foregoing implementation, the first three-way valve 51 may be alternatively replaced with two solenoid valves (not shown in the figure). One solenoid valve is connected between the second pipeline 42 and the condenser 321, and the other solenoid valve is connected between the second pipeline 42 and the heat exchanger 31. The controller 60 is configured to simultaneously control the two solenoid valves to be linked, and may also have the foregoing effect of distributing a flow quantity of the refrigerant.

In addition, when the composite refrigeration system 100 in this application is applied to another operation scenario other than the data center, the controller 60 may also be communicatively connected to a heat source in the another operation scenario, and accordingly adjust flow distribution of the refrigerant by monitoring a workload of the heat source in real time, to achieve a corresponding effect of controlling the heat dissipation mode of the heat dissipation part 30.

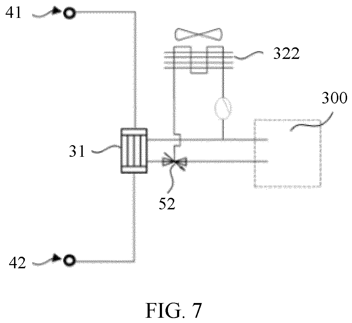

For illustration of another implementation of the composite refrigeration system 100 in this application, refer to FIG. 6 and FIG. 7. In this implementation, a structure of the refrigeration part 20 is consistent with that of the implementation described above, and the cooler 32 of the heat dissipation part 30 is implemented by using a dry cooler 322. In the heat dissipation part 30, the dry cooler 322 is connected in parallel to the external pipeline network 300, and a medium flowing in the dry cooler 322 is a heat carrier, instead of the refrigerant in the implementation described above. The dry cooler 322 also includes a heat dissipation fin and a fan, and may perform air-cooled heat dissipation on the heat carrier to achieve an indirect heat dissipation effect on a refrigerant in the heat dissipation part 30.

Specifically, the heat dissipation part 30 also includes the heat exchanger 31, and the heat exchanger 31 is connected between the second pipeline 42 and the first pipeline 41, and is also disposed opposite to the external pipeline network 300. When flowing through the heat exchanger 31, the refrigerant may implement heat exchange with the heat carrier in the external pipeline network 300. To be specific, in this implementation, the refrigerant is directly heat dissipated only by using the heat exchanger 31, and the heat is transferred to the heat carrier. The dry cooler 322 is connected in parallel to the external pipeline network 300. The heat carrier that completes heat exchange with the refrigerant may flow directly into a rear end of the external pipeline network 300, or may flow into the dry cooler 322 at least partially. After the dry cooler 322 performs air-cooled heat dissipation on the heat carrier, the heat carrier then flows into the rear end of the external pipeline network 300. By controlling a flow quantity of a heat carrier flowing into the dry cooler 322, a heat dissipation effect of the dry cooler 322 on the heat carrier may be controlled, so that the heat dissipation effect is formed on the refrigerant when the heat carrier obtained after being heat dissipated performs heat exchange with the refrigerant again. In other words, in this implementation, the dry cooler 322 indirectly controls a heat dissipation effect of the refrigerant by controlling heat dissipation of the heat carrier.

In the composite refrigeration system 100 in this implementation, when the heat carrier flows only in the external pipeline network 300 and does not enter the dry cooler 322 for heat dissipation (that is, the second heat dissipation mode), all heat in the refrigerant is exchanged to the heat carrier. In this way, an energy recycle efficiency of the composite refrigeration system 100 in this application is relatively high, and a heating effect on the heat carrier is relatively strong. However, when all the heat carrier enters the dry cooler 322 for heat dissipation (that is, the first heat dissipation mode), a temperature of the heat carrier flowing into the rear end of the external pipeline network 300 is lower, or the heat exchanger 31 and the dry cooler 322 directly form a heat dissipation path. The composite refrigeration system 100 no longer conveys the heat carrier to the external pipeline network 300. In this case, the energy recycle efficiency of the composite refrigeration system 100 is relatively low.

In an implementation, the composite refrigeration system 100 further includes a second three-way valve 52. The second three-way valve 52 is connected between the heat exchanger 31, the external pipeline network 300, and the dry cooler 322, and is configured to control the flow quantity of the heat carrier flowing into the dry cooler 322 for heat dissipation and distribution of a flow quantity of the heat carrier flowing into the rear end of the external pipeline network 300, that is, control the heat dissipation mode of the heat dissipation part 30. Specifically, the second three-way valve 52 includes one second liquid inlet port and two second liquid outlet ports. The second liquid inlet port is connected to the heat exchanger 31, one second liquid outlet port is connected to the dry cooler 322, and the other second liquid outlet port is connected to the rear end of the external pipeline network 300. Therefore, the heat carrier that completes heat exchange from the heat exchanger 31 may flow into the second three-way valve 52 through the second liquid inlet port, and flow into the dry cooler 322 through the second liquid outlet port for heat dissipation, or directly flow into the rear end of the external pipeline network 300 through the other second liquid outlet port separately.

Similar to the implementations shown in FIG. 2 and FIG. 5, the composite refrigeration system 100 in this application may also implement distribution of a flow quantity of a heat carrier flowing through the dry cooler 322 and a flow quantity of a heat carrier directly flowing into the rear end of the external pipeline network 300 by controlling the second three-way valve 52 by the controller 60, to achieve an effect of simultaneously controlling heat dissipation of the dry cooler 322 and controlling a heating temperature of the heat carrier. It may be understood that the controller 60 may control the second three-way valve 52 based on a heat dissipation requirement of the heat carrier or based on a heating temperature required by the heat carrier. When the heat carrier needs to be heat dissipated more, the controller 60 may control more of the heat carrier to flow into the dry cooler 322, so that more of the heat carrier can be heat dissipated by using the dry cooler 322. The controller 60 may also control more of the heat carrier to flow toward the rear end of the external pipeline network 300 when the external pipeline network 300 requires more heat. Further, the controller 60 may also implement control of a temperature of the heat carrier in the dry cooler 322 or the heat exchanger 31 by controlling a fan speed of the dry cooler 322, controlling a flow rate of the heat carrier in the external pipeline network 300, or the like.

In an implementation, as shown in FIG. 6, the composite refrigeration system 100 of this implementation is also provided with the temperature sensor 70. The temperature sensor 70 is disposed in the equipment room 200 of the data center, and is configured to monitor a temperature in the equipment room 200 of the data center. The temperature sensor 70 is communicatively connected to the controller 60 to transmit a detected temperature value of the equipment room 200 of the data center to the controller 60. After receiving the temperature value, the controller 60 may control the second three-way valve 52 to distribute a flow quantity of the heat carrier. In some implementations, the controller 60 may be alternatively communicatively connected to the server 201 in the equipment room 200 of the data center for monitoring a real-time workload of the server 201 and then controlling flow distribution of a heat carrier in the second three-way valve 52 based on the workload. The controller 60 may alternatively receive the temperature value obtained through monitoring by the temperature sensor 70 and workload data of the server 201 at the same time, and distribute a flow quantity of the heat carrier, to ensure a refrigerating effect of the composite refrigeration system 100 and a heating effect on the heat carrier at the same time. In some implementations, the second three-way valve 52 may be alternatively replaced with two solenoid valves. For related implementations, refer to descriptions of the implementations in FIG. 1 to FIG. 5. Details are not described one by one again in this specification.

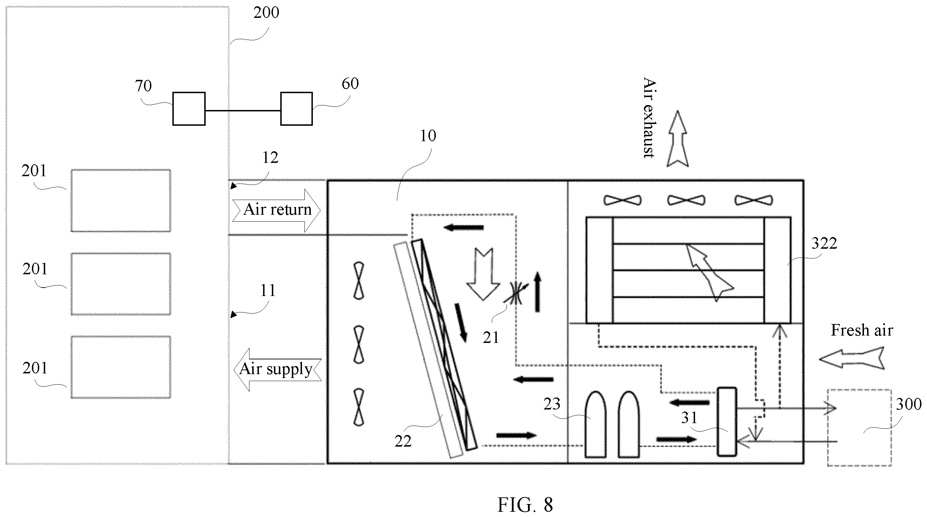

Therefore, referring to FIG. 8, arrangement of the composite refrigeration system 100 in an operation scenario is similar to arrangement in the operation scenario shown in FIG. 1 in an implementation in which the cooler 32 is the dry cooler 322. A difference lies in a change in a connection manner of the heat exchanger 31, the cooler 32, the external pipeline network 300, and the like. To be specific, in the operation scenario shown in FIG. 1, the heat exchanger 31 is connected in parallel to the condenser 321, and the condenser 321 may directly dissipate heat for the refrigerant. However, in the operation scenario shown in FIG. 8, the dry cooler 322 is connected in parallel to the external pipeline network 300, and the dry cooler 322 dissipates heat for the heat carrier.

In addition, in the illustration of FIG. 8, the dry cooler 322 is disposed in a sealed compartment, and the compartment is provided with at least two air vents, so that external air enters the compartment through one air vent, completes heat exchange with the dry cooler 322, and then flows out from another air vent. It may be understood that the compartment in which the dry cooler 322 is located is separated from the circulating ventilation channel 10, and the external air does not enter the equipment room 200 of the data center through the circulating ventilation channel 10, to ensure environmental cleanliness of the equipment room 200 of the data center.

However, as mentioned above, that the refrigeration part 20 is located in the circulating ventilation channel 10 is represented as follows: The evaporator 22 is disposed in the circulating ventilation channel 10 in the illustration of FIG. 8. Because the evaporator 22 needs to come into contact and exchange heat with air sent into the equipment room 200 of the data center, to perform refrigeration on the air, the evaporator 22 needs to be disposed in the circulating ventilation channel 10, to come into direct contact with the air. However, as shown in FIG. 8, the compressor 23 in the refrigeration part 20 may be located outside the circulating ventilation channel 10. Because the compressor 23 may generate heat during operation, the compressor 23 is disposed outside the circulating ventilation channel 10 to prevent the heat of the compressor 23 from affecting a refrigerating effect of the composite refrigeration system 100. The electronic expansion valve 21 may be disposed inside the circulating ventilation channel 10, or disposed outside the circulating ventilation channel 10 along with the compressor 23, and a location of the electronic expansion valve 21 does not greatly affect the refrigerating effect. The heat exchanger 31 and the compressor 23 may be disposed in the same compartment. Because the heat exchanger 31 achieves a refrigerating effect of the refrigerant by exchanging heat with the external pipeline network 300, the heat generated when the compressor 23 operates does not greatly affect the heat exchanger 31.

Correspondingly, in the illustration of FIG. 1, the condenser 321 may also be disposed in the sealed compartment, and flow of the external air in the compartment is implemented through the two air vents, to achieve a heat dissipation effect of the condenser 321 on the refrigerant. The compartment in which the condenser 321 is located also needs to be separated from the circulating ventilation channel 10, to ensure cleanliness of the equipment room 200 of the data center.

In the illustration of FIG. 1, the evaporator 22 is also disposed in the circulating ventilation channel 10, and is configured to come into direct contact with air in the circulating ventilation channel 10, to implement a refrigerating function of the composite refrigeration system 100 in this application. A location of the electronic expansion valve 21, a location of the compressor 23, and a location of the heat exchanger 31 are also similar to the solution shown in FIG. 8. In a process of ensuring normal operation of the composite refrigeration system 100, an integration degree of components in the composite refrigeration system 100 is increased.

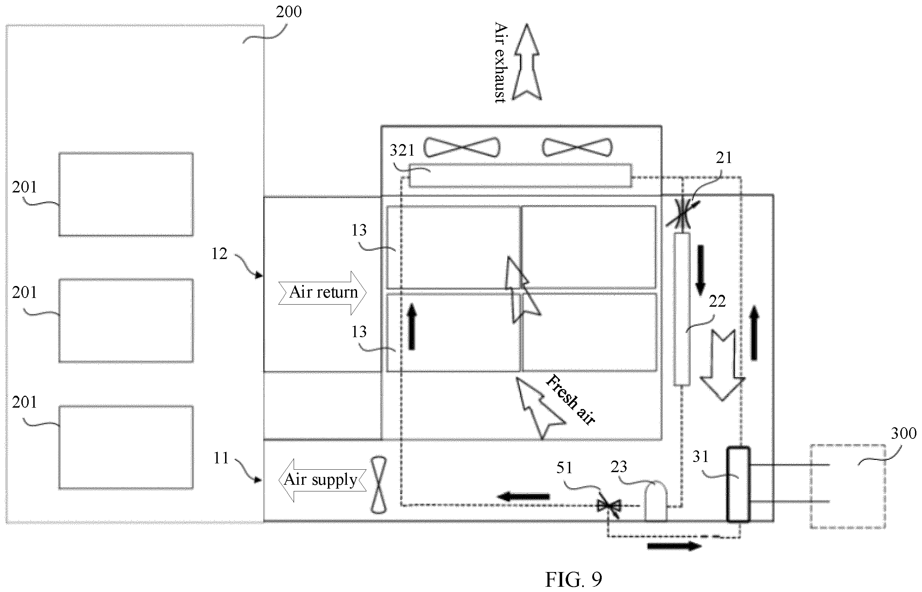

In an implementation, referring to FIG. 9, a heat exchange core 13 is further disposed in the circulating ventilation channel 10. The heat exchange core 13 and the circulating ventilation channel 10 are sealed and isolated from each other. The heat exchange core 13 is located between the air outlet port 12 and the evaporator 22, and an outdoor ventilation path of the heat exchange core 13 is further connected in series to a ventilation path of the cooler 32. The outdoor ventilation path of the heat exchange core 13 is isolated from a ventilation path of the circulating ventilation channel 10. The outdoor ventilation path of the heat exchange core 13 is used for circulating external air, and forms heat exchange with air in the air outlet port 12 of the circulating ventilation channel 10 through the external air (shown as fresh air in the figure), to further form pre-heat dissipation for air flowing out of the air outlet port 12, thereby reducing a temperature of the air flowing out of the air outlet port 12. In some implementations, when a temperature of external fresh air is relatively high, a spraying structure may be further disposed at the heat exchange core 13, to perform cooling processing on fresh air passing through the heat exchange core 13, thereby implementing pre-heat dissipation. The pre-heat dissipated air re-flows to the evaporator 22 for refrigeration, and finally enters the equipment room 200 of the data center from the air supply port 11 through the circulating ventilation channel 10.

After pre-heat dissipation of the external air is completed at the heat exchange core 13, the external air enters the cooler 32 (shown as the condenser 321 in FIG. 9), and air-cooled heat dissipation is performed on the cooler 32 (shown as air exhaust in the figure). Because a temperature of air of which pre-heat dissipation is completed at the heat exchange core 13 is lower than a temperature of a refrigerant that needs to be heat dissipated, after the external air enters the heat exchange core 13 to form pre-heat dissipation, a heat dissipation effect of the external air at the condenser 321 may still be ensured. In the implementation shown in FIG. 9, the external air may successively dissipate heat for air in the circulating ventilation channel 10 and air in the condenser 321, to improve utilization of the external air, reduce a workload of the evaporator 22 accordingly, and also achieve an effect of saving energy.

In this implementation, because the heat exchange core 13 occupies specific space, the heat exchanger 31 and the compressor 23 may be alternatively disposed in the circulating ventilation channel 10, to increase an integration degree of the composite refrigeration system 100.

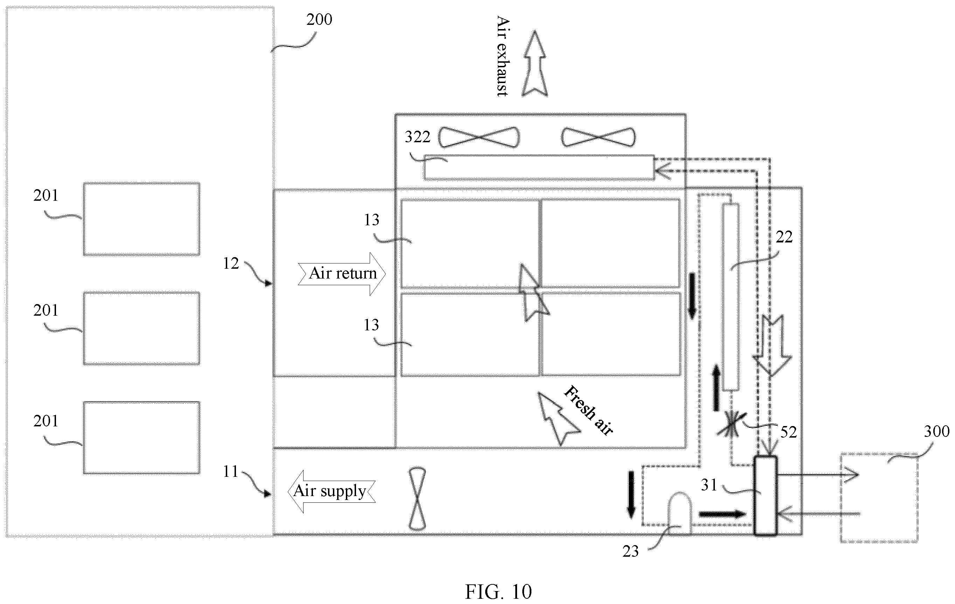

In the implementation shown in FIG. 10, when the cooler 32 is implemented by using the dry cooler 322, the heat exchange core 13 may be alternatively disposed in the circulating ventilation channel 10. The heat exchange core 13 is also located between the air outlet port 12 and the evaporator 22, and is configured to introduce the external air to perform pre-heat dissipation on air flowing out of the air outlet port 12, to reduce a workload of the evaporator 22, and achieve the effect of saving energy. In addition, the heat exchange core 13 may be connected in series to the dry cooler 322. After heat exchange is completed on the external air at the heat exchange core 13, an air temperature of the external air is lower than a temperature of a heat carrier in the dry cooler 322. Therefore, after pre-heat dissipation of the external air is completed, a heat dissipation effect of the external air at the dry cooler 322 may still be ensured. In other words, in the implementation shown in FIG. 10, the external air successively dissipates heat for the air in the circulating ventilation channel 10 and the heat carrier in the dry cooler 322, thereby also improving the utilization of the external air.

The scope of protection is defined by the appended claims.

## Claims

1. A composite refrigeration system (100), comprising a refrigeration part (20), a heat dissipation part (30), a first pipeline (41), a second pipeline (42), and a refrigerant, wherein
the first pipeline (41) is connected between the refrigeration part (20) and the heat dissipation part (30), and is configured to send the refrigerant from the heat dissipation part (30) to the refrigeration part (20);
the refrigeration part (20) is connected to an indoor space, and is configured to use the refrigerant to cool air sent into the indoor space; and
the second pipeline (42) is also connected between the refrigeration part (20) and the heat dissipation part (30), and is configured to send the refrigerant from the refrigeration part (20) to the heat dissipation part (30), wherein
the heat dissipation part (30) comprises a heat exchanger (31) and a cooler (32), and the heat dissipation part (30) comprises three heat dissipation modes for the refrigerant:
in a first heat dissipation mode, the heat dissipation part (30) performs air-cooled heat dissipation on the refrigerant by using the cooler (32) alone;
in a second heat dissipation mode, the heat dissipation part (30) exchanges heat between the refrigerant and a heat carrier in an external pipeline network (300) by using the heat exchanger (31) alone, to perform heat dissipation; and
in a third heat dissipation mode, the heat dissipation part (30) performs heat dissipation on the refrigerant by simultaneously using the cooler (32) and the heat exchanger (31);
wherein the cooler (32) is a condenser (321), the condenser (321) is connected in parallel to the heat exchanger (31), and the condenser (321) is configured to directly perform air-cooled heat dissipation on the refrigerant;
wherein the composite refrigeration system (100) further comprises a controller (60) and a first three-way valve (51), three ports of the first three-way valve (51) are respectively connected to the second pipeline (42), the heat exchanger (31), and the condenser (321), and the controller (60) controls the first three-way valve (51) to adjust the heat dissipation mode of the heat dissipation part (30);
wherein the refrigeration part (20) comprises an electronic expansion valve (21), an evaporator (22), and a compressor (23) that are sequentially connected, the electronic expansion valve (21) is located on a side that is of the evaporator (22) and that is close to the first pipeline (41), and the compressor (23) is located on a side that is of the evaporator (22) and that is close to the second pipeline (42);
wherein the composite refrigeration system (100) further comprises a circulating ventilation channel (10), an air supply port (11) and an air outlet port (12) of the circulating ventilation channel (10) are separately connected to the indoor space, and the refrigeration part (20) is disposed in the circulating ventilation channel (10) and is configured to refrigerate air flowing out of the air outlet port (12), and send refrigerated air into the indoor space through the air supply port (11);
wherein the evaporator (22) is disposed in the circulating ventilation channel (10) and is configured to come into direct contact with the air of the circulating ventilation channel.

2. The composite refrigeration system (100) according to claim 1, wherein the cooler (32) is a dry cooler (322), the dry cooler (322) is connected in parallel to the external pipeline network (300), and the dry cooler (322) performs air-cooled heat dissipation on the heat carrier to implement indirect air-cooled heat dissipation on the refrigerant.

3. The composite refrigeration system (100) according to claim 2, wherein the composite refrigeration system (100) further comprises a controller (60) and a second three-way valve (52), three ports of the second three-way valve are respectively connected to the heat exchanger (31), the external pipeline network (300), and the dry cooler (32), and the controller (60) controls the second three-way valve to adjust the heat dissipation mode of the heat dissipation part (30).

4. The composite refrigeration system (100) according to claim 1 or 3, wherein the composite refrigeration system (100) further comprises a temperature sensor (70), the temperature sensor is disposed in the indoor space for monitoring a temperature in the indoor space, the temperature sensor is electrically connected to the controller (60), and the controller (60) controls the first three-way valve (51) or the second three-way valve (52) with reference to a temperature value detected by the temperature sensor.

5. The composite refrigeration system (100) according to any one of claims 1 to 4, wherein a heat exchange core (13) is further disposed in the circulating ventilation channel (10), the heat exchange core (13) is located between the air outlet port (12) and the refrigeration part (20), external air flows at the heat exchange core (13), and the heat exchange core (13) is configured to introduce the external air to perform pre-refrigeration on the air flowing out of the air outlet port (12).

6. A data center, comprising an equipment room (200) and the composite refrigeration system (100) according to any one of claims 1 to 5, wherein the refrigeration part (20) is connected to an indoor space of the equipment room (200).

7. The data center according to claim 6, wherein the composite refrigeration system (100) comprises a controller (60), a server (201) is disposed in the equipment room (200), the controller (60) is communicatively connected to the server (201), and the controller (60) is configured to control a heat dissipation mode of the composite refrigeration system (100) with reference to a workload of the server (201).

## Patentansprüche

1. Verbundkühlsystem (100), das ein Kühlteil (20), ein Wärmeableitungsteil (30), eine erste Rohrleitung (41), eine zweite Rohrleitung (42) und ein Kältemittel umfasst, wobei die erste Rohrleitung (41) zwischen dem Kühlteil (20) und dem Wärmeableitungsteil (30) verbunden und konfiguriert ist, um das Kältemittel von dem Wärmeableitungsteil (30) zu dem Kühlteil (20) zu transportieren;
das Kühlteil (20) mit einem Innenraum verbunden und konfiguriert ist, um das Kältemittel zu verwenden, um Luft, die in den Innenraum transportiert wird, zu kühlen; und
die zweite Rohrleitung (42) ebenfalls zwischen dem Kühlteil (20) und dem Wärmeableitteil (30) verbunden und konfiguriert ist, um das Kältemittel von dem Kühlteil (20) zu dem Wärmeableitungsteil (30) zu transportieren, wobei
das Wärmeableitungsteil (30) einen Wärmetauscher (31) und eine Kühlvorrichtung (32) umfasst und das Wärmeableitungsteil (30) für das Kältemittel drei Wärmeableitungsmodi umfasst:
in einem ersten Wärmeableitungsmodus führt das Wärmeableitungsteil (30) unter alleiniger Verwendung der Kühlvorrichtung (32) eine luftgekühlte Wärmeableitung durch;
in einem zweiten Wärmeableitungsmodus tauscht das Wärmeableitungsteil (30) Wärme zwischen dem Kältemittel und einem Wärmeträger in einem externen Rohrleitungsnetzwerk (300) unter alleiniger Verwendung des Wärmetauschers (31) aus, um eine Wärmeableitung durchzuführen; und
in einem dritten Wärmeableitungsmodus führt das Wärmeableitungsteil (30) durch gleichzeitiges Verwenden der Kühlvorrichtung (32) und des Wärmetauschers (31) bei dem Kältemittel eine Wärmeableitung durch;
wobei die Kühlvorrichtung (32) ein Verdichter (321) ist, der Verdichter (321) parallel zu dem Wärmetauscher (31) verbunden ist und der Verdichter (321) konfiguriert ist,
um direkt bei dem Kältemittel luftgekühlte Wärmeableitung durchzuführen;
wobei das Verbundkühlsystem (100) ferner eine Steuerung (60) und ein erstes Dreiwegeventil (51) umfasst, drei Anschlüsse des ersten Dreiwegeventils (51) jeweils mit der zweiten Rohrleitung (42), dem Wärmetauscher (31) und dem Verdichter (321) verbunden sind und die Steuerung (60) das erste Dreiwegeventil (51) steuert, um den Wärmeableitungsmodus des Wärmeableitungsteils (30) einzustellen;
wobei das Kühlteil (20) ein elektronisches Expansionsventil (21), einen Verdampfer (22) und einen Verdichter (23) umfasst, die in Reihe verbunden sind, wobei sich das elektronische Expansionsventil (21) auf einer Seite des Verdampfers (22) befindet, die nahe der ersten Rohrleitung (41) liegt, und sich der Verdichter (23) auf einer Seite des Verdampfers (22) befindet, die nahe der zweiten Rohrleitung (42) liegt;
wobei das Verbundkühlsystem (100) ferner einen umlaufenden Belüftungskanal (10) umfasst, eine Luftzufuhröffnung (11) und eine Luftauslassöffnung (12) des umlaufenden Belüftungskanals (10) getrennt mit dem Innenraum verbunden sind und das Kühlteil (20) in dem umlaufenden Belüftungskanal (10) angeordnet und konfiguriert ist, um aus der Luftauslassöffnung (12) strömende Luft zu kühlen und durch die Luftzufuhröffnung (11) Kühlluft in den Innenraum zu transportieren;
wobei der Verdampfer (22) in dem umlaufenden Belüftungskanal (10) angeordnet ist und konfiguriert ist, um mit der Luft des umlaufenden Belüftungskanals in direkten Kontakt zu kommen.

2. Verbundkühlsystem (100) nach Anspruch 1, wobei die Kühlvorrichtung (32) ein Trockenkühler (322) ist, der Trockenkühler (322) parallel zu dem externen Rohrleitungsnetzwerk (300) verbunden ist und der Trockenkühler (322) bei dem Wärmeträger eine luftgekühlte Wärmeableitung durchführt, um bei dem Kältemittel eine indirekte luftgekühlte Wärmeableitung zu implementieren.

3. Verbundkühlsystem (100) nach Anspruch 2, wobei das Verbundkühlsystem (100) ferner eine Steuerung (60) und ein zweites Dreiwegeventil (52) umfasst, drei Anschlüsse des zweiten Dreiwegeventils jeweils mit dem Wärmetauscher (31), dem externen Rohrleitungsnetzwerk (300) und dem Trockenkühler (32) verbunden sind und die Steuerung (60) das zweite Dreiwegeventil steuert, um den Wärmeableitungsmodus des Wärmeableitungsteils (30) einzustellen.

4. Verbundkühlsystem (100) nach Anspruch 1 oder 3, wobei das Verbundkühlsystem (100) ferner einen Temperatursensor (70) umfasst, wobei der Temperatursensor zum Überwachen einer Temperatur in dem Innenraum angeordnet ist, wobei der Temperatursensor elektrisch mit der Steuerung (60) verbunden ist und die Steuerung (60) das erste Dreiwegeventil (51) oder das zweite Dreiwegeventil (52) unter Bezugnahme auf einen durch den Temperatursensor erfassten Temperaturwert steuert.

5. Verbundkühlsystem (100) nach einem der Ansprüche 1 bis 4, wobei in dem umlaufenden Belüftungskanal (10) ferner ein Wärmeaustauschkern (13) angeordnet ist, wobei sich der Wärmeaustauschkern (13) zwischen der Luftauslassöffnung (12) und dem Kühlteil (20) befindet, externe Luft an dem Wärmetauscherkern (13) strömt und der Wärmeaustauschkern (13) konfiguriert ist, um die externe Luft zuzuführen, um an der aus der Luftauslassöffnung (12) strömenden Luft eine Vorkühlung durchzuführen.

6. Rechenzentrum, das einen Geräteraum (200) und das Verbundkühlsystem (100) nach einem der Ansprüche 1 bis 5 umfasst, wobei das Kühlteil (20) mit einem Innenraum des Geräteraums (200) verbunden ist.

7. Rechenzentrum nach Anspruch 6, wobei das Verbundkühlsystem (100) eine Steuerung (60) umfasst, ein Server (201) in dem Geräteraum (200) angeordnet ist, die Steuerung (60) kommunikativ mit dem Server (201) verbunden ist und die Steuerung (60) konfiguriert ist, um einen Wärmeableitungsmodus des Verbundkühlsystems (100) unter Bezugnahme auf eine Arbeitslast des Servers (201) zu steuern.

## Revendications

1. Système de réfrigération composite (100), comprenant une partie de réfrigération (20), une partie de dissipation de chaleur (30), une première conduite (41), une seconde conduite (42) et un réfrigérant, dans lequel la première conduite (41) est raccordée entre la partie de réfrigération (20) et la partie de dissipation de chaleur (30), et est conçue pour envoyer le réfrigérant de la partie de dissipation de chaleur (30) à la partie de réfrigération (20) ;
la partie de réfrigération (20) est raccordée à un espace intérieur, et est conçue pour utiliser le réfrigérant pour refroidir l'air envoyé dans l'espace intérieur ; et
la seconde conduite (42) est également raccordée entre la partie de réfrigération (20) et la partie de dissipation de chaleur (30), et est conçue pour envoyer le réfrigérant de la partie de réfrigération (20) à la partie de dissipation de chaleur (30), dans lequel
la partie de dissipation de chaleur (30) comprend un échangeur de chaleur (31) et un refroidisseur (32), et la partie de dissipation de chaleur (30) comprend trois modes de dissipation de chaleur pour le réfrigérant :
dans un premier mode de dissipation de chaleur, la partie de dissipation de chaleur (30) effectue une dissipation de chaleur refroidie par air sur le réfrigérant à l'aide uniquement du refroidisseur (32) ;
dans un deuxième mode de dissipation de chaleur, la partie de dissipation de chaleur (30) échange de la chaleur entre le réfrigérant et un caloporteur dans un réseau de conduite extérieur (300) à l'aide uniquement de l'échangeur de chaleur (31), pour effectuer une dissipation de chaleur ; et
dans un troisième mode de dissipation de chaleur, la partie de dissipation de chaleur (30) effectue une dissipation de chaleur sur le réfrigérant à l'aide simultanément du refroidisseur (32) et de l'échangeur de chaleur (31) ;
dans lequel le refroidisseur (32) est un condenseur (321), le condenseur (321) est connecté en parallèle à l'échangeur de chaleur (31), et le condenseur (321) est configuré pour effectuer directement une dissipation de chaleur refroidie par air sur le réfrigérant ;
dans lequel le système de réfrigération composite (100) comprend en outre un dispositif de commande (60) et une première vanne à trois voies (51), trois ports de la première vanne à trois voies (51) sont respectivement raccordés à la seconde canalisation (42), à l'échangeur de chaleur (31) et au condenseur (321), et le dispositif de commande (60) commande la première vanne à trois voies (51) pour ajuster le mode de dissipation de chaleur de la partie de dissipation de chaleur (30) ;
dans lequel la partie de réfrigération (20) comprend un détendeur électronique (21), un évaporateur (22) et un compresseur (23) qui sont connectés séquentiellement, le détendeur électronique (21) est situé sur un côté qui est de l'évaporateur (22) et qui est proche de la première conduite (41), et le compresseur (23) est situé sur un côté qui est de l'évaporateur (22) et qui est proche de la seconde conduite (42) ;
dans lequel le système de réfrigération composite (100) comprend en outre un canal de ventilation par circulation (10), un port
d'alimentation en air (11) et un port de sortie d'air (12) du canal de ventilation par circulation (10) sont raccordés séparément à l'espace intérieur, et la partie de réfrigération (20) est disposée dans le canal de ventilation par circulation (10) et est configurée pour réfrigérer l'air s'écoulant du port de sortie d'air (12), et envoyer l'air réfrigéré dans l'espace intérieur à travers le port d'alimentation en air (11) ;
dans lequel l'évaporateur (22) est disposé dans le canal de ventilation par circulation (10) et est conçu pour entrer en contact direct avec l'air du canal de ventilation par circulation.

2. Système de réfrigération composite (100) selon la revendication 1, dans lequel le refroidisseur (32) est un refroidisseur à sec (322), le refroidisseur à sec (322) est raccordé en parallèle au réseau de conduite extérieur (300), et le refroidisseur à sec (322) effectue une dissipation de chaleur refroidie par air sur le caloporteur pour mettre en oeuvre une dissipation de chaleur par air indirecte sur le réfrigérant.

3. Système de réfrigération composite (100) selon la revendication 2, dans lequel le système de réfrigération composite (100) comprend en outre un dispositif de commande (60) et une seconde vanne à trois voies (52), trois ports de la seconde vanne à trois voies sont respectivement raccordés à l'échangeur de chaleur (31), au réseau de conduite extérieur (300) et au refroidisseur à sec (32), et le dispositif de commande (60) commande la seconde vanne à trois voies pour ajuster le mode de dissipation de chaleur de la partie de dissipation de chaleur (30).

4. Système de réfrigération composite (100) selon la revendication 1 ou 3, dans lequel le système de réfrigération composite (100) comprend en outre un capteur de température (70), le capteur de température est disposé dans l'espace intérieur pour surveiller une température dans l'espace intérieur, le capteur de température est connecté électriquement au dispositif de commande (60), et le dispositif de commande (60) commande la première vanne à trois voies (51) ou la seconde vanne à trois voies (52) en référence à une valeur de température détectée par le capteur de température.

5. Système de réfrigération composite (100) selon l'une quelconque des revendications 1 à 4, dans lequel un noyau d'échange de chaleur (13) est en outre disposé dans le canal de ventilation par circulation (10), le noyau d'échange de chaleur (13) est situé entre l'orifice de sortie d'air (12) et la partie de réfrigération (20), l'air extérieur s'écoule au niveau du noyau d'échange de chaleur (13), et le noyau d'échange de chaleur (13) est configuré pour introduire l'air extérieur pour effectuer une pré-réfrigération sur l'air s'écoulant hors de l'orifice de sortie d'air (12).

6. Centre de données, comprenant une salle d'équipement (200) et le système de réfrigération composite (100) selon l'une quelconque des revendications 1 à 5, dans lequel la partie de réfrigération (20) est raccordée à un espace intérieur de la salle d'équipement (200).

7. Centre de données selon la revendication 6, dans lequel le système de réfrigération composite (100) comprend un dispositif de commande (60), un serveur (201) est disposé dans la salle d'équipement (200), le dispositif de commande (60) est connecté en communication au serveur (201), et le dispositif de commande (60) est configuré pour commander un mode de dissipation de chaleur du système de réfrigération composite (100) en référence à une charge de travail du serveur (201).
